# EUROPEAN PATENT APPLICATION

(11) **EP 4 528 759 A1**
(43) Date of publication of application: **26.03.2025**
(21) Application number: 23275134.7
(22) Date of filing: 19.09.2023
(51) Int. Cl.: H01F 6/04, H01F 6/06, F17C 13/08, G01R 33/38, F25D 19/00

(54) **MEANS FOR SEALING A PENETRATION IN A CRYOGENIC DEVICE**

(71) Applicant: Siemens Healthcare Limited, Camberley, Surrey GU15 3YL (GB)
(72) Inventor: Bickell, William, Witney, OX28 5FX (GB); Chase, Gobinder, Oxford, OX2 9GF (GB); Chorley, Simon, Oxford, OX2 9BN (GB)
(74) Representative: Maier, Daniel Oliver

(57) **Abstract**

The invention relates to a suspension rod (12) for suspending a main magnet (17) of a magnetic resonance device (11), comprising a first end, a second end, and a collar (51) configured for deflecting thermal radiation, wherein the collar (51) is mechanically connected to the suspension rod (12) and wherein the collar (51) circumferentially encompasses the suspension rod (12) along a section of the suspension rod (12) located between the first end and the second end. Furthermore, the invention relates to a shielding assembly (31) comprising an inventive suspension rod (12) and a magnetic resonance device (11) comprising an inventive shielding assembly (31).

## Description

Independent of the grammatical term usage, individuals with male, female or other gender identities are included within the term.

Cryogenic devices, such as magnetic resonance devices, usually comprise one or more thermal radiation shields maintained at an intermediate temperature level between a temperature of the cryogenic application and an ambient temperature. These thermal radiation shields surround cryogenically cooled components of the cryogenic devices to prevent thermal radiation from reaching the cryogenically cooled components. Typically, the cryogenically cooled components and the one or more thermal shields are enclosed in a vacuum vessel to shield the cryogenically cooled components from a surrounding environment and reduce heat transport due to heat convection.

The cryogenically cooled components are typically supported by dedicated support structures, which must be routed through the thermal radiation shields. For example, superconducting magnets in magnetic resonance devices can be suspended via dedicated suspension elements passing through holes in the thermal radiation shields. These holes must be sealed or made light-tight to prevent thermal radiation from entering a region encompassed by the thermal radiation shield.

In cryogenic devices having only a single thermal shield, the holes in the thermal shield may be accessed from outside the vacuum vessel before the cryogenic device is closed up. Alternatively, the hole can be sealed before loading the cryogenically cooled components and the thermal radiation shield into the vacuum vessel. For example, specially designed blankets of multi-layer insulation can be wrapped around the holes in the thermal shield to provide a seal against thermal radiation.

In cryogenic devices comprising two or more thermal shields, for example an inner thermal shield and at least one outer thermal shield encompassing the inner thermal shield, an accessibility of the inner thermal shield may be reduced significantly. Furthermore, build tolerances in the cryogenic devices, but also transport of the cryogenic device, require the seals to allow for relative movement between the suspension elements and the thermal radiation shield(s).

It is an objective of the invention to allow for a sealing of a hole in a thermal shield in confined spaces with reduced accessibility. It is a further objective of the invention to allow for a relative movement between a support structure of the cryogenically cooled components and the thermal shield.

These objectives are achieved by a suspension rod and a shielding assembly according to the invention. Further advantageous embodiments are specified in the dependent claims.

The inventive suspension rod is configured for suspending a main magnet of a magnetic resonance device. The inventive suspension rod comprises a first end, a second end, and a collar configured for deflecting thermal radiation.

Preferably, the suspension rod consists of a material with high tensile strength. Examples of suitable materials are metals, particularly stainless steel, or composite materials, such as fibre reinforced plastics, and the like. According to an embodiment, a shaft of the suspension rod comprises carbon fibres. For example, the shaft of the suspension rod may consist of a carbon fibre reinforced polymer.

The suspension rod may have a cylindrical or a prismatic shape. For example, the suspension rod may correspond to a pole or bar comprising an oval or polygonal cross-section. Preferably, the suspension rod has an elongated or oblong shape.

The first end and the second end of the suspension rod may each comprise an anchor or ferrule. The anchor or ferrule may be attached to the suspension rod via any suitable mechanical connection, such as a form-locking connection, a force-locking connection and/or a material bond. For example, the anchor or ferrule may be clamped, wedged and/or glued to the suspension rod. However, any suitable mechanical connection may be used. The anchor or ferrule may be configured to mechanically engage with a support structure, such as an outer vacuum chamber, a support structure of a main magnet, or the like.

The collar may comprise a support element wrapped in a thermally insulating material. For example, the support element may be wrapped in a multi-layer insulation. However, the collar may also consist of a thermally insulating material, such as a multi-layer insulation. In a preferred embodiment, the collar is configured to deflect or block thermal radiation. Preferably, the thermally insulating material has a low emissivity (i. e. effectiveness in emitting energy as thermal radiation), e. g. ranging between 0,01 and 0,05. Suitable thermally insulating materials may be polymers or plastics, such as polyethylene, polyurethane, polyimide (i. e. Kapton), but also carbon, carbon composites, silica composites, and the like. A thermally insulating material may have a low thermal conductivity, for example a thermal conductivity of less than 1 ***W*/(*m* · *K*),** less than 0.5 ***W*/(*m · K*),** or less than 0.1 ***W*/(*m · K*)** at a temperature level below 100 K.

According to a preferred embodiment, the collar comprises or consists of a low-emissivity material. For example, the collar may comprise or consist of a multi-layer insulation. The multi-layer insulation (MLI) may consist of several layers of metal-vaporized plastic foils, which are kept at a distance by spacers. For example, a foil may consist of polyester or polyimide sheet which is aluminised on both sides. The spacers may consist of woven or non-woven sheets or gauzes made from polyester or polyimide.

In providing an inventive suspension rod comprising a collar, an effectiveness of blocking or deflecting thermal radiation passing through a hole or passage in a thermal shield covered by the collar may favourably be increased. Thus, a heat load in cryogenically cooled components of the cryogenic device may favourably be reduced.

In an embodiment of the inventive suspension rod, a section of the suspension rod located between the collar and the second end is wrapped in a thermally insulating material. The thermally insulating material may correspond to an embodiment described above. Preferably, the thermally insulating material has a low emissivity. It is also conceivable that a section of the suspension rod located between the collar and the first end is wrapped in a thermally insulating material. According to a preferred embodiment, the thermally insulating material is a multi-layer insulation.

In wrapping sections of the suspension rod of a cryogenic device in a thermally insulating material, a share of black body radiation emitted by the suspension rod may favourably be deflected or prevented from reaching cryogenically cooled components of the cryogenic device.

According to the invention, the collar is mechanically connected to the suspension rod. Particularly, the suspension rod may provide mechanical support to the collar. For example, the collar may be taped, glued, tied and/or soldered to a shaft of the suspension rod. However, the collar may be mechanically connected to the suspension rod via any suitable mechanical connection, such as a form-locking connection, a force-locking connection and/or a material bond. In some embodiments, the collar may be clamped, bolted and/or screwed to the suspension rod.

The collar circumferentially encompasses the suspension rod along a section of the suspension rod located between the first end and the second end. Preferably, the collar is attached to the suspension rod in such a way, that thermal radiation is prevented from passing through an interfacial region between the collar and the suspension rod. Particularly, the collar may form a light-tight seal around the shaft of the suspension rod.

The collar may be configured to abut against a thermal shield and/or to cover a hole or passage in a thermal shield of a shielding assembly according to an embodiment described below. For example, the collar be arranged between the first end and the second end of the suspension rod in such a way, that the collar contacts or abuts against the thermal shield when the first end of the suspension rod is mechanically connected to a main magnet and the second end of the suspension rod is mechanically connected to an outer vacuum chamber of a magnetic resonance device.

An inventive suspension rod may favourably allow for sealing a passage or hole in a thermal radiation shield in confined or inaccessible spaces. Thus, requirements regarding accessibility of the thermal shield may favourably be relaxed. An inventive suspension rod may also allow for reducing a dimension or footprint of a cryogenic device comprising inventive suspension rods in comparison to conventional cryogenic devices.

The inventive suspension rod may favourably facilitate a manufacturing process for a cryogenic device, such as a magnetic resonance device. For example, the suspension rod may automatically prevent thermal radiation from passing through a hole or passage in a thermal shield when arranged in a predefined relative position to the thermal shield. Thus, a separate step or process of sealing the passage in the thermal shield may favourably be omitted.

Furthermore, the inventive suspension rod allows for mechanically decoupling the cryogenically cooled components of the cryogenic device from the thermal shield. Particularly, an inventive suspension rod comprising a collar may favourably allow for a relative movement between the suspension rod and the thermal shield, while still preventing thermal radiation from passing through a gap between the suspension rod and the thermal shield.

The inventive suspension rod may favourably decrease manufacturing costs of a cryogenic device, but also a heat load on cryogenically cooled components of the cryogenic device.

According to an embodiment of the inventive suspension rod, the collar consists of a flexible material and comprises the shape of a cone.

A flexible material may represent a material which can be manually deformed. Preferably, the collar consists of an MLI blanket or a single polymer sheet metallized on both sides. For example, the collar may comprise or consist of a sheet of metallized polymer, particularly BoPET (biaxially oriented polyethylene terephthalate), having a thickness of 6 to 12 pm. The polymer sheet may comprise an aluminium film on each side having a thickness of 20 to 100 nm.

The collar may comprise a tapered section. Particularly, the collar may taper towards the second end of the suspension rod. For example, a first diameter of a section of the collar located closer to the first end of the suspension rod may exceed a second diameter of a section of the collar located closer to the second end of the suspension rod. The collar may be shaped as a cone, a frustrum, a hemisphere, or the like.

The collar may be formed by cutting a flat flexible material into circle. A section of the circle, for example a quarter of the circle or a third of the circle, may be cut out and edges of the remaining circle may be joined to form a cone. The edges may be connected via a tape, particularly a low-emissivity tape, an adhesive, particularly an epoxy resin, and/or staples. Other ways of joining the edges are of course conceivable.

The inventive suspension rod may be formed by sliding the collar onto the shaft of the suspension rod. The collar may be secured to the suspension rod via a tape, a cable tie, an adhesive, or any suitable mechanical connection. The cone of the collar may be inverted to stabilize the collar and/or to provide a reliable seal between a section of the cone of the collar and a perimeter of a passage in a thermal shield.

In providing a collar having a tapered shape, manufacturing tolerances of the cryogenic device may favourably be compensated. Particularly, the tapered section of the collar may favourably compensate for a misalignment or relative movement between the suspension rod and a thermal shield.

According to a further embodiment of the inventive suspension rod, the collar comprises a rigid or semi-rigid material and comprises the shape of a disk.

A rigid material may be any material capable of maintaining a predefined shape while a moderate force, particularly a manual force, is applied. A rigid material may comprise or consist of a plastic, a composite, a metal, or the like. Preferably, the disk-shaped collar consists of a metal plate, particularly an aluminium plate. However, the collar may also comprise a support element made of a plastic, a metal, or a composite material. The support element may be wrapped in a thermally insulating material, particularly a low-emissivity material, according to an embodiment described above. For example, the support element may be wrapped in an MLI blanket.

It is also conceivable that the collar comprises a semi-rigid material. A semi-rigid material may be any material capable of reversibly deforming when a moderate force is applied. Preferably, the semi-rigid material is configured to resume to an original shape after an applied force is withdrawn. The collar may comprise a support element made of a thin metal, a plastic, or a composite material. The support element may be wrapped in a thermally insulating material according to an embodiment described above, particularly an MLI blanket. For example, the semi-rigid material of the collar may comprise or consist of a sheet of metallized polymer, particularly BoPET, having a thickness of 125 to 500 pm. The polymer sheet may comprise an aluminium film on each side having a thickness of 20 to 100 nm.

The collar may be configured to cover or occlude a passage in a thermal shield. Preferably, a diameter of the collar exceeds a diameter of the passage in the thermal shield. In one embodiment, the collar is arranged between the first end and the second end of the suspension rod in such a way that the collar, particularly a circumferential section of the collar, abuts against the thermal shield when the suspension rod is routed through the passage in the thermal shield.

In providing an inventive suspension rod comprising a rigid or semi-rigid collar, a particularly robust and/or reliable seal between the suspension rod and a thermal shield may be provided. When installed in an inventive shielding assembly according to an embodiment described below, the inventive suspension rod may favourably allow for movement of the suspension rod and build tolerance in a local plane of a surface of a thermal shield.

According to an embodiment of the inventive suspension rod, the collar comprises a semi-rigid material. The collar comprises a first section and a second section, wherein the first section comprises the shape of a disk or a cone and wherein a lateral surface of the second section is angled with respect to a lateral surface of the first section.

A semi-rigid material may correspond to a material described above. The first section and the second section of the collar may be formed from one piece. According to an embodiment, a tapering of a lateral surface of the first section may deviate from a tapering of a lateral surface of the second section. For example, the second section may be bend or deformed in such a way that the second section is angled with respect to the first section. In a preferred embodiment, the first section of the collar comprises the shape of a disk, whereas the lateral surface of the second section tapers towards the first end of the suspension rod.

It is also conceivable that the first section and the second section represent separate pieces which are joined along an outer circumference of the first section, for example via an adhesive, staples and/or a (low-emissivity) tape.

An inventive suspension rod comprising a collar having at least a first section and a second section angled with respect to the first section may favourably provide a well-defined area of contact between the collar and an area surrounding a hole or passage in a thermal shield. Furthermore, a collar comprising a first section and a second section according to an embodiment described above may favourably provide an increased flexibility in comparison to a disk-shaped or cone-shaped collar. Thus, the inventive suspension rod may favourably allow for a compensation of relative movement between the suspension rod and a thermal shield.

According to an embodiment of the inventive suspension rod, a longitudinal axis of the collar is angled with respect to a longitudinal axis of a shaft of the suspension rod.

The longitudinal axis of the collar may correspond to a cone axis or a cylinder axis of the collar. It is conceivable that the collar has a rotationally symmetric shape. In such a case, an axis of rotational symmetry of the collar may be angled with respect to the longitudinal axis of the shaft of the suspension rod.

Due to spatial requirements, but also mechanical design aspects, the suspension rod may need to be routed through a passage in a thermal shield at an oblique angle or a non-perpendicular angle with respect to the thermal shield. Collars made of a rigid or semi-rigid material may impede a consistent or uninterrupted seal around the hole or passage in the thermal shield. Thus, the collar may be mechanically attached to the suspension rod in such a way that the longitudinal axis of the collar is angled with respect to the longitudinal axis of the shaft of the suspension rod.

In an embodiment, the suspension rod comprises a base element configured for orienting the collar in such a way that the longitudinal axis of the collar is angled with respect to the longitudinal axis of the shaft of the suspension rod. The base element may be configured to mechanically connect the collar to the suspension rod. It is conceivable that the base element comprises a moveable joint or hinge configured for modifying an angle between the longitudinal axis of the collar and the longitudinal axis of the shaft of the suspension rod. However, the base element may also be configured to attach the collar to the suspension rod in a predefined or fixed orientation. The base element may be used in conjunction with a collar consisting of a flexible material according to an embodiment described above.

A collar comprising a longitudinal axis which is angled with respect to a longitudinal axis of the shaft of the suspension rod may favourably provide a seal against the thermal shield, even when the suspension rod is arranged at an oblique angle with respect to the thermal shield. In mounting the collar on a base element comprising a moveable joint or hinge, the base element may favourably compensate for relative movement between the suspension rod and the thermal shield, for example during installation of the suspension rod, but also during transport of the cryogenic device.

In a preferred embodiment, the inventive suspension rod comprises a thermal intercept including a thermal link thermally and mechanically connected to the thermal intercept. The thermal intercept is configured for thermally connecting the suspension rod to a cold source.

The thermal intercept may represent a thermal connection, a thermal junction, or a thermal joint. The thermal intercept is thermally and mechanically connected to the suspension rod. For example, the thermal intercept may represent a thermally conductive element attached to the suspension rod. The thermally conductive element may comprise a bracket, a clamp, a tube, a ring, a sleeve, or the like. The thermally conductive element may be mechanically connected to the suspension rod via a force-locking connection, a form-locking connection and/or a material bond. For example, the thermally conductive element may be clamped, swaged, and/or crimped onto the suspension rod. It is also conceivable, that the thermally conductive element is attached to the suspension rod via an adhesive, particularly a thermally conductive adhesive. Preferably, the thermally conductive element comprises or consists of a thermally conductive material, for example a metal and/or a thermally conductive composite material.

According to the invention, the thermal intercept includes a thermal link which is thermally and mechanically connected to the thermal intercept. It is conceivable, that the thermal link forms part of the thermal intercept and/or the thermally conductive element. However, the thermal link may also represent a separate component thermally and mechanically connected to the thermal intercept and/or the thermally conductive element. In a preferred embodiment, the thermally conductive element and/or the thermal link may comprise or consist of a flexible thermal conductor, such as a copper braid.

The thermal intercept is configured for thermally connecting the suspension rod to a cold source. Particularly, the thermal intercept may be configured to absorb heat energy from the suspension rod and transfer the heat energy to a cold source thermally and mechanically connected to the thermal link. The cold source may be any component connected to a cooling stage of a cryocooler, e. g. a thermal shield or a component of a shielding assembly according to an embodiment described below, but also the cooling stage of the cryocooler itself.

According to the invention, the thermal intercept is thermally and mechanically connected to a section of the suspension rod located between the first end and the collar. Particularly, a position of the thermal intercept may correspond to a position of the collar. Preferably, a distance between the thermal intercept and the first end of the suspension exceeds a distance between the thermal intercept and the second end of the thermal intercept. It is conceivable that a distance between the thermal intercept and the second end of the suspension rod is at least 10 cm, at least 15 cm, at least 20 cm, at least 30 cm, or at least 40 cm.

The thermal link is spaced from the suspension rod along a section of the suspension rod located between the thermal intercept and the second end. For example, the thermal link is kept at a distance from the suspension rod along the section of the suspension rod located between the thermal intercept and the second end. The thermal link may also be guided or routed at a distance from the suspension rod along the section of the suspension rod located between the thermal intercept and the second end. Preferably, the thermal link is kept at a distance of at least 0,5 mm, at least 1 mm, or at least 2 mm from the shaft of the suspension rod along the section of the suspension rod located between the thermal intercept and the second end. The distance between the thermal link and the shaft of the suspension rod may vary along the section of the suspension rod located between the thermal intercept and the second end. According to an embodiment, a contact between the thermal link and the shaft of the suspension rod along the section of the suspension rod located between the thermal intercept and the second end is avoided. In a preferred embodiment, a thermally insulating material is disposed between the thermal link and the shaft of the suspension rod. The thermally insulating material may be configured to space or separate the thermal link from the suspension rod, but also to maintain a distance between the thermal link and the suspension rod.

In a preferred embodiment of the inventive suspension rod, the thermal link comprises a flexible thermal conductor. The flexible thermal conductor may be plastically or elastically deformable. Particularly, the flexible thermal conductor may be manually deformable. It is conceivable that the flexible thermal conductor is configured to be bent and/or deformed to allow for installing the suspension rod into an inventive shielding assembly. Particularly, the flexible thermal conductor may allow for circumventing obstacles or components of the shielding assembly and/or other support structures of the cryogenic device when mechanically connecting the thermal link to a cold source, such as a thermal shield. It is also conceivable that the flexible thermal conductor is configured to be routed around bends or corners, preferably while the suspension rod is attached to a main magnet (or a support structure supporting the main magnet) and an outer vacuum chamber of a magnetic resonance device according to an embodiment described below.

According to an embodiment of the inventive suspension rod, the flexible thermal conductor consists of a flexible metal fabric, such as a metal braid, a metal mesh, or a metal weave. Preferably, the flexible thermal conductor consists of a copper braid.

A thermal link comprising a flexible thermal conductor may favourably allow for thermally connecting the suspension rod to a cold source spatially separated or spaced from the thermal intercept. Furthermore, a flexible thermal conductor can be guided or routed around an obstacle, such as a corner or a component of the shielding assembly and/or a support structure of a cryogenic device. Thus, thermally connecting individual suspension rods to a cold source in a complex three-dimensional arrangement of a shielding assembly may favourably be facilitated.

The collar may encompass the suspension rod and the thermal link along a section of the suspension rod located between the thermal intercept and the second end of the suspension rod. Preferably, the collar is mechanically connected to the thermal intercept and/or the thermal link. Particularly, the thermal intercept may be configured to provide mechanical support to the collar. For example, the collar may be taped, glued, and/or soldered to the thermal intercept and/or the thermal link. Preferably, the collar is attached to the suspension rod and/or the thermal intercept in such a way, that thermal radiation is prevented from passing through an interfacial region between the collar and the thermal intercept and/or the thermal link.

The inventive shielding assembly comprises a suspension rod according to an embodiment described above, a thermal shield, and an outer vacuum chamber.

The thermal shield may be configured to reduce a transport of heat energy to cryogenically cooled components of a cryogenic device, particularly a main magnet of a magnetic resonance device. A transport of heat energy may be characterized by a heat transport mechanism such as thermal radiation, heat conduction, but also heat convection. The thermal shield may be configured to circumferentially encompass a main magnet of a magnetic resonance device. For example, the thermal shield may form a vessel configured to enclose the main magnet. In a preferred embodiment, the thermal shield comprises an outer wall, an inner wall and annular end walls connecting the outer wall and the inner wall. Particularly, the thermal shield may form a double-walled hollow cylinder configured to enclose the main magnet between the outer wall, the inner wall and the annular end walls. A cylinder axis of the thermal shield may be oriented in parallel to or correspond an axis of rotational symmetry defined by the solenoidal coil of the main magnet.

The thermal shield may be an intermediate thermal shield. For example, the thermal shield may be maintained at a temperature level between 4K and 60 K. It is conceivable that the thermal shield is configured to prevent heat energy, particularly thermal radiation, from entering a region enclosed by the thermal shield (e. g. a region enclosed between the outer wall and the inner wall of the thermal shield).

The thermal shield may comprise or consist of coated or galvanized plastic or polymer. For example, the thermal shield may consist of an aluminized plastic, such as polyethylene terephthalate (PET) or other polymers. In certain embodiments, the plastic or polymer may be coated, plated, or laminated with a thermally conductive metal, such as gold, silver, aluminium, copper, or platinum. Preferably, the thermal shield has a low emissivity, e. g. below 0.1 or below 0.05.

In a preferred embodiment, the thermal shield corresponds to an inner thermal shield enclosed by an outer thermal shield or further thermal shield.

The outer vacuum chamber may form a vessel which is substantially impermeable to fluids, such as a liquid or a gaseous cryogen. The vacuum chamber may be configured to maintain a vacuum in an inner volume encompassed by the vacuum chamber. Preferably, the outer vacuum chamber encompasses the cryogenically cooled components of a magnetic resonance device. For example, the outer vacuum chamber encompasses a cryogen vessel, the thermal shield, a further thermal shield, and the main magnet.

According to an embodiment, the outer vacuum chamber comprises an outer shell, an inner shell and annular end walls connecting the outer shell and the inner shell. The outer vacuum chamber may form a double-walled hollow cylinder configured to enclose a main magnet and the thermal shield between the outer shell, the inner shell, and the annular end walls. A cylinder axis of the outer vacuum chamber may be oriented in parallel to or correspond an axis of rotational symmetry defined by a solenoidal coil of the main magnet. The inner shell of the outer vacuum chamber may correspond to a patient bore of a magnetic resonance device.

The main magnet of a magnetic resonance device may comprise or consist of one or more electromagnets or superconducting magnets. Particularly, the main magnet may comprise or consist of one or more solenoidal or cylindrical superconducting magnets or superconducting coils. The main magnet may comprise a dedicated support structure configured to carry the main magnet and/or provide support to the main magnet. Thus, the term main magnet as used herein may comprise one or more solenoidal superconducting coil, but also a dedicated support structure.

According to the invention, the second end of the suspension rod is mechanically connected to the outer vacuum chamber.

In a preferred embodiment, the suspension rod is configured to provide a mechanical connection between the outer vacuum chamber and the main magnet of a magnetic resonance device. The outer vacuum chamber may be configured to provide mechanical support to the suspension rod and the main magnet. The outer vacuum chamber may also be configured to provide mechanical support to the thermal shield and/or a further thermal shield. For example, the thermal shield and/or the further thermal shield may be carried by or suspended from the outer vacuum chamber.

As described above, the first end and/or the second end of the suspension rod may comprise an anchor or a ferrule. The anchor or ferrule at the first end of the suspension rod may be configured to mechanically engage with the main magnet of a magnetic resonance device. Likewise, the anchor or ferrule at the second end of the suspension rod may be configured to mechanically engage with the outer vacuum chamber. Thus, the suspension rod may be held under tension when mechanically connected to the main magnet and the outer vacuum chamber. The suspension rod may be mechanically connected to the main magnet and the outer vacuum chamber via any suitable mechanical connection. For example, the suspension rod may be screwed, clamped, and/or bolted to the main magnet (or a support structure supporting the main magnet). It is also conceivable that the suspension rods are mechanically connected to the outer vacuum chamber and/or the main magnet via hooks.

According to the invention, the suspension rod is routed through a passage in the thermal shield. The passage in the thermal shield may represent a hole, a bore, a slot, or a cavity extending through a material or wall of the thermal shield. The suspension rod may pass through the passage in the thermal shield to provide a mechanical connection between the main magnet and the outer vacuum chamber.

The collar is configured to engage with the thermal shield and cover a gap between the thermal shield and the suspension rod.

For example, the collar may cover and/or obstruct the passage in the thermal shield. It is conceivable that a part or section of the collar extends through the passage in the thermal shield. Particularly, the collar may be configured to block a gap between the suspension rod and the thermal shield. According to an embodiment, the collar is configured to abut against the thermal shield and thus prevent thermal radiation from passing through the passage in the thermal shield.

In a preferred embodiment, the collar comprises a low-emissivity material, such as MLI. The MLI may be configured to block or deflect thermal radiation. When installed in an inventive shielding assembly, the suspension rod comprising a collar made from MLI may support establishing a stable thermal gradient between a thermal shield and an outer vacuum chamber encompassing the thermal shield.

As described above, the collar may comprise a tapered section. According to an embodiment, the tapered section has a first diameter smaller than a diameter of the passage in the further thermal shield and a second diameter exceeding the diameter of the passage in the further thermal shield. Thus, the collar may form a plug configured for plugging or occluding the passage in the thermal shield when the suspension rod is installed in the shielding assembly in an intended relative position with respect to the thermal shield.

The collar may also be shaped as a disk. In this case, the collar may be configured to abut against the thermal shield, thus occluding or covering any potential gap between the passage in the further thermal shield and the suspension rod.

In a preferred embodiment, a location of the collar along the suspension rod may substantially correspond to a location of the thermal shield along the suspension rod.

The inventive shielding assembly shares the advantages of the inventive suspension rod according to an embodiment described above. Particularly, the inventive shielding assembly may reduce or offset limitations, particularly geometric restrictions, related to sealing a gap between the suspension rod and the thermal shield, especially in presence of at least one further thermal shield.

In providing an inventive shielding assembly including a suspension rod comprising a collar, an amount of thermal radiation passing through a gap or interfacial region between the suspension rod and the thermal shield may be reduced or minimized. Thus, a cooling capacity required for maintaining a main magnet at a superconducting temperature may favourably be decreased. Furthermore, the inventive shielding assembly may favourably allow for a relative movement between the suspension rod and the thermal shield without reducing a sealing effectiveness, but also compensate for construction tolerances of the shielding assembly.

According to a preferred embodiment, the inventive shielding assembly comprises a further thermal shield.

The further thermal shield may form a vessel comprising an outer wall, an inner wall and annular end walls connecting the outer wall and the inner wall. Particularly, the further thermal shield may form a double-walled hollow cylinder configured to enclose the thermal shield between the outer wall, the inner wall, and the annular end walls of the further thermal shield. A longitudinal axis or cylinder axis of the further thermal shield may be oriented in parallel to or correspond to an axis of rotational symmetry defined by the thermal shield and/or a solenoidal coil of a main magnet enclosed by the further thermal shield.

Preferably, the further thermal shield comprises or consists of a material with a high electrical conductivity and/or a high thermal conductivity. For example, the further thermal shield may consist of copper or aluminium, particularly a copper alloy or an aluminium alloy. The further thermal shield may also comprise gold, platinum, silver, or other materials with a high thermal conductivity. In one embodiment, the further thermal shield is coated or galvanized with gold, platinum, or other metals with high thermal conductivity.

According to the invention, the suspension rod is routed through a passage in the further thermal shield. Preferably, the suspension rod extends through a passage in the thermal shield and a passage in the further thermal shield. Particularly, the suspension rod may extend through passages in the thermal shield and the further thermal shield to provide a mechanical connection between the outer vacuum chamber and a main magnet of a magnetic resonance device.

In a preferred embodiment, the further thermal shield corresponds to a primary thermal shield or a 50K shield of a magnetic resonance device.

In a further embodiment of the inventive shielding assembly, the thermal link is thermally and mechanically connected to the further thermal shield. For example, the thermal intercept of the suspension rod may be mechanically and thermally connected to the further thermal shield via a copper braid.

The further thermal shield comprises a thermal insulation configured to cover a gap between the further thermal shield and the suspension rod.

For example, the further thermal shield may be wrapped in an assembly of MLI blankets configured to provide a thermal insulation from a region encompassing the further thermal shield. Preferably, at least one MLI patch of the assembly of MLI blankets may abut against the suspension rod to cover a gap between the suspension rod and the assembly of MLI blankets. The at least one MLI patch may be taped to the assembly of MLI blankets.

According to an embodiment, the thermal intercept of the suspension rod is mechanically and thermally connected to the further thermal shield via the thermal link. Preferably, the thermal link is configured to bridge a distance between the thermal intercept and the further thermal shield. Thus, the thermal link may extend through the passage in the thermal shield. Particularly, the thermal link may provide a thermal and mechanical connection between the thermal intercept and the further thermal shield. The thermal intercept may be mechanically connected to a section of the suspension rod located between the first end of the suspension rod and the thermal shield.

In a preferred embodiment, the further thermal shield is thermally connected to a cryocooler, particularly a first stage of a cryocooler. Thus, the suspension rod may be thermally connected to the cryocooler via the thermal intercept, the thermal link, and the further thermal shield.

In providing an inventive shielding assembly comprising a further thermal shield, a share of thermal radiation entering a region or volume directly surrounding a main magnet of a magnetic resonance device may be reduced or minimized. Thus, a cooling capacity required for cooling the main magnet may favourably be decreased.

According to an embodiment, the inventive shielding assembly comprises a further thermal shield, wherein the suspension rod is routed through a passage in the further thermal shield. The suspension rod comprises a further collar configured to engage with the further thermal shield and cover a gap between the further thermal shield and the suspension rod.

The further thermal shield may correspond to a primary thermal shield or a 50K shield as described above.

The further collar may correspond to an embodiment of the collar described above. For example, the further collar may be mechanically connected to the suspension rod and/or a base element mechanically connected to the suspension rod. The further collar may comprise the shape of a cone, a disk, or a combination thereof.

The further collar may be arranged along the suspension rod in such a way, that the further collar contacts or abuts against the further thermal shield, when the suspension rod is installed in the shielding assembly in an intended relative position with respect to the further thermal shield. For example, the further collar may form a plug configured for plugging or occluding a gap between the suspension rod and the further thermal shield.

In providing a suspension rod comprising a collar and a further collar, a process of sealing or covering passages in a plurality of thermal shields may favourably be facilitated. For example, in using an inventive suspension rod, a plurality of passages in a plurality of thermal shields may be covered automatically, when the suspension rod is mechanically connected to the main magnet and the outer vacuum chamber of a magnetic resonance device.

The inventive shielding assembly comprises a suspension rod, a thermal shield, and an outer vacuum chamber.

The thermal shield and the outer vacuum chamber may be configured according to an embodiment described above. It is conceivable that the suspension rod comprises a thermal intercept and a thermal link according to an embodiment described above. The suspension rod of the inventive shielding assembly described below may be embodied without a collar.

The second end of the suspension rod is mechanically connected to the outer vacuum chamber and the suspension rod is routed through a passage in the thermal shield. The suspension rod may extend through the passage in the thermal shield according to an embodiment described above.

According to the invention, the thermal shield comprises a cover comprising a thermally insulating material, wherein the cover is mechanically attached to the thermal shield in such a way to occlude the passage in the thermal shield. The suspension rod pierces the cover to pass through the passage in the thermal shield.

The thermally insulating material may correspond to a thermally insulating material described above. Preferably, the thermally insulating material comprises or consists of one or more MLI blankets. For example, a surface of the thermal shield comprising the passage may be wrapped in one or more MLI blankets. It is conceivable that the thermally insulating material comprises a flexible base material carrying one or more MLI blankets.

The suspension rod may pierce the thermally insulating material where the suspension rod extends through the thermal shield. Preferably, the thermally insulating material is configured to provide a seal around the shaft of the suspension rod. For example, the thermally insulating material may comprise an elastic material configured to cling to the suspension rod which pierces the material. According to an embodiment, the suspension rod comprises a taper or an anchor element positioned between the first end and the second end. The taper or anchor element may provide an extension of a cross-sectional area of the suspension rod. Particularly, the taper or anchor element may prevent the thermally insulating material from slipping over the taper or anchor element in a direction towards the first end of the suspension rod. An anchor element may comprise a nut, a ring, a sleeve, or the like. The anchor element may be mechanically connected to a shaft of the suspension rod. For example, the anchor element may be clamped, swaged, glued, or soldered to the suspension rod.

Preferably, the thermally insulating material forms a bag or sock in a region of the passage. Thus, the thermally insulating material may favourably allow for a relative movement between the suspension rod and the thermal shield without tearing or being damaged.

The inventive shielding assembly may favourably allow for sealing a gap between the suspension rod and the thermal shield without requiring direct access to the passage in the thermal shield when the shielding assembly is assembled.

According to an embodiment of the inventive suspension rod, the cover is mechanically connected to a surface of the thermal shield comprising the passage.

In a preferred embodiment, the cover is mechanically connected to a radially outer surface of the thermal shield or a surface of the thermal shield facing towards the outer wall of the outer vacuum chamber.

The cover forms a protrusion arranged over the passage in the thermal shield. For example, the cover may form a bag or sock arranged over the passage in the thermal shield. The bag or sock may be configured to extend through the passage in the thermal shield. Preferably, the cover forms a bag or sock configured to extend through the passage in the thermal shield to a side of the thermal shield facing away from or opposing the surface of the thermal shield mechanically connected to the cover. For example, the bag or sock of the cover may be configured to extend through the passage in the thermal shield to a side of the thermal shield facing away from the outer wall of the outer vacuum chamber. However, the bag or sock may also be accommodated on or extend along a side of the thermal shield facing towards the outer wall of the outer vacuum chamber.

The cover may comprise or consist of a flexible material, particularly a flexible material having a low emissivity. For example, the cover may comprise or consist of one or more MLI blankets or one or more metallized or double-metallized polymer sheets, particularly BoPET sheets. Preferably, the cover consists of sheet of BoPET having a thickness of 6 to 12 pm. The sheet of BoPET may comprise an aluminium film on each side having a thickness of 20 to 100 nm.

In providing a cover formed as a bag or sock, the thermally insulating material may favourably allow for a relative movement between the suspension rod and the thermal shield, but also facilitate manufacturing the shielding assembly, without tearing or being damaged. Thus, a reliability of sealing a gap between the suspension rod and the thermal shield may favourably be increased.

According to an embodiment, the inventive shielding assembly comprises a fastener configured to attach a part of the cover to the suspension rod.

For example, the fastener may comprise a tie, a cable tie, and/or an anchor element according to an embodiment described above.

Preferably, the sock or bag formed by the cover comprises a surplus of material which allows the suspension rod to be mechanically connected to the cover via the fastener prior to mechanically connecting the suspension rod to the outer vacuum chamber. For example, the shielding assembly may be configured to allow at least a section of the suspension rod to be stowed in a region encompassed by the thermal shield. The suspension rod may then be retracted from the region encompassed by the thermal shield through the passage in the thermal shield to mechanically connect the suspension rod to the outer vacuum chamber.

An inventive shielding assembly comprising a fastener may favourably allow for significant relative movement between the suspension rod and the thermal shield. Thus, a process of installing the suspension rod into an inventive shielding assembly may favourably be facilitated.

The inventive magnetic resonance device is configured to acquire magnetic resonance data from an object positioned within an imaging region of the magnetic resonance device. Preferably, the magnetic resonance device is configured to acquire magnetic resonance image data, particularly diagnostic magnetic resonance image data, from the object positioned within the imaging region. The object may be a patient, particularly a human or an animal.

Preferably, the inventive magnetic resonance device is a closed bore scanner. A closed bore scanner may comprise a substantially cylindrical bore circumferentially enclosing the imaging region. A main magnet of the closed bore scanner may comprise one or more solenoid coils circumferentially encompassing the imaging region along an axial direction or an axis of rotational symmetry of the cylindrical bore. The one or more solenoid coils may comprise a wire having negligible electrical resistance at (or below) a superconducting temperature. A direction of a main magnetic field provided via the main magnet may be oriented substantially in parallel to a direction of access of the object to the imaging region and/or the axial direction of the cylindrical bore.

According to the invention, the magnetic resonance device comprises a shielding assembly according to an embodiment described above.

The magnetic resonance device may comprise at least one cryocooler. The at least one cryocooler may be configured to cool components of the magnetic resonance device. For example, the at least one cryocooler may be configured to cool the main magnet, the shielding assembly, the thermal shield, the further thermal shield, a cryogen vessel, a support structure, and the like.

The at least one cryocooler may be configured to provide a temperature close to or lower than a superconducting temperature of a superconducting material of the main magnet. For example, the superconducting temperature of the main magnet may be in the range of 3 K to 100 K, preferably in the range of 3 K to 6 K, 30 K to 60 K, or 60 K to 90 K. The at least one cryocooler may be implemented as a pulse tube refrigerator, a Gifford-McMahon refrigerator, a Stirling cryocooler, a Joule-Thomson cryocooler, or the like.

In a preferred embodiment, the at least one cryocooler is thermally and mechanically connected to the main magnet and the further thermal shield. The at least one cryocooler may be configured to maintain the main magnet and the further thermal shield, at different temperature levels. For example, the at least one cryocooler may comprise at least a first cooling stage and a second cooling stage. The first cooling stage may be thermally and mechanically connected to the shielding assembly. The second stage may be thermally and mechanically connected to the main magnet. Preferably, a temperature level of the first cooling stage exceeds a temperature level of the second stage. For example, the first cooling stage may be configured to provide a temperature in the range between 30 K to 180 K, preferably in the range between 40 K to 60 K, 60 K to 100 K, or 100 K to 180 K. The second cooling stage may be configured to provide a temperature level close to the superconducting temperature of the main magnet.

The inventive magnetic resonance device may represent a "dry" system comprising a minimum of cryogen or no cryogen at all. For example, the inventive magnetic resonance device may comprise one or more small cryogen vessels thermally connected to the main magnet via a solid thermal conductor. The small cryogen vessels may contain a volume of less than 10 l, less than 5 l, or less than 1 1 of cryogen. In an embodiment of the inventive magnetic resonance device, a cryogen vessel is omitted. Thus, the main magnet may be cooled entirely via thermal conduction.

The cryogen vessel may be configured for storing or preserving a fluid, particularly a cryogen, at a predefined temperature level. Preferably, the fluid or cryogen exhibits a low boiling point, such as Argon, Nitrogen, Neon, Helium, or the like. The predefined temperature level may substantially correspond to a superconducting temperature of the main magnet.

It is conceivable that the components of the magnetic resonance device, such as the main magnet, the thermal shield, the further thermal shield, one or more suspension rods and/or a the cryogen vessel, are thermally connected to the at least one cryocooler, preferably via a solid thermal conductor, a convection loop and/or a heat pipe.

As described above, the shielding assembly may be configured to reduce a transport of heat energy to the main magnet. Preferably, the thermal shield and/or the further thermal shield are configured to prevent thermal radiation from reaching the main magnet. For example, an outer wall of the thermal shield may be configured to block or deflect incoming thermal radiation from a direction of a surrounding environment, while an inner wall of the thermal shield may be configured to block or deflect incoming thermal radiation from a direction of a patient bore of the magnetic resonance device. A surface of the thermal radiation shield directed away from the main magnet may be wrapped in MLI and/or comprise a cover according to an embodiment described above. The magnetic resonance device may comprise a further thermal shield comprising an outer wall and an inner wall configured to block or deflect incoming thermal radiation from the surrounding environment and the patient bore in a similar fashion.

In a preferred embodiment, the main magnet is suspended from the outer shell of the outer vacuum chamber via a plurality of suspension rods.

The inventive magnetic resonance device shares the advantages of the inventive suspension rod and the inventive shielding assembly.

Further advantages and details of the present invention may be recognized from the embodiments described below as well as the drawings. The figures show:
Fig. 1 a schematic representation of an embodiment of an inventive magnetic resonance device,
Fig. 2 a schematic representation of an embodiment of an inventive magnetic resonance device,
Figs. 3a,3b a schematic representation of an embodiment of an inventive suspension rod,
Figs. 4a,4b a schematic representation of an embodiment of an inventive shielding assembly,
Figs. 5a,5b a schematic representation of an embodiment of an inventive shielding assembly,
Figs. 6a,6b a schematic representation of an embodiment of an inventive shielding assembly,
Figs. 7a,7b a schematic representation of an embodiment of an inventive shielding assembly,
Figs. 8a,8b a schematic representation of an embodiment of an inventive shielding assembly,
Figs. 9a,9b a schematic representation of an embodiment of an inventive shielding assembly.

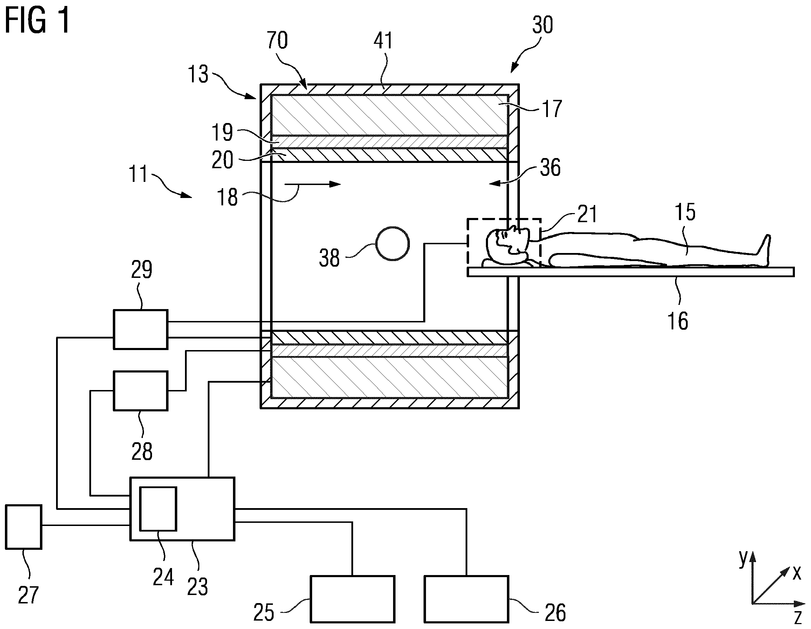

Fig. 1 shows an embodiment of a magnetic resonance device 11 according to the invention. In the illustrated example, the magnetic resonance device 11 comprises a static field magnet 17 (or main magnet) configured to provide a homogenous, static magnetic field 18 (B0 field) comprising an isocentre 38. The static magnetic field 18 permeates a cylindrical imaging region 36 configured for receiving an imaging object, such as a patient 15. The imaging region 36 may substantially correspond to a volume of a patient bore configured for accommodating a patient 15 during a magnetic resonance measurement. The imaging region 36 is encompassed by the field generation unit 30 in a circumferential direction.

In the depicted example, the magnetic resonance device 11 comprises a patient support 16 configured to transport the patient 15 into the imaging region 36. The patient support 16 may transport a diagnostically relevant body region of the patient 15 into an imaging volume defined by the isocentre 38 of the magnetic resonance device 11. Typically, the field generation unit 30 of the magnetic resonance device 11 is concealed in a housing 41.

The magnetic resonance device 11 may comprise a gradient system 19 configured to provide magnetic gradient fields used for spatial encoding of magnetic resonance signals acquired during a magnetic resonance measurement. The gradient system 19 is activated or controlled by a gradient controller 28 via an appropriate current signal. It is conceivable that the gradient system 19 comprises one or more gradient coils for generating magnetic gradient fields in different, preferably orthogonally oriented, spatial directions.

The magnetic resonance device 11 may comprise an integrated radiofrequency antenna 20 (i. e. a body coil). The radiofrequency antenna 20 is operated via a radiofrequency controller 29 that controls the radiofrequency antenna 20 to generate a high frequency magnetic field and emit radiofrequency excitation pulses into the imaging region 36. The magnetic resonance imaging device 11 may further comprise a local coil 21, which is positioned on or in proximity to the diagnostically relevant region of the patient 15. The local coil 21 may be configured to emit radiofrequency excitation pulses into the patient 15 and/or receive magnetic resonance signals from the patient 15. It is conceivable, that the local coil 21 is controlled via the radiofrequency controller 29.

The magnetic resonance device 11 further comprises a control unit 23 configured for controlling the magnetic resonance device 11. The control unit 23 may comprise a processing unit 24 configured to process magnetic resonance signals and reconstruct magnetic resonance images. The processing unit 24 may also be configured to process input from a user of the magnetic resonance device 11 and/or provide an output to a user. For this purpose, the processing unit 24 and/or the control unit 23 can be connected to a display unit 25 and an input unit 26 via a suitable signal connection. For a preparation of a magnetic resonance measurement, preparatory information, such as imaging parameters or patient information, can be provided to the user via the display unit 25. The input unit 26 may be configured to receive information and/or imaging parameters from the user.

The magnetic resonance imaging device 11 may comprise further components that magnetic resonance imaging devices usually offer. The general operation of a magnetic resonance imaging device 11 is known to those skilled in the art, so a more detailed description is omitted.

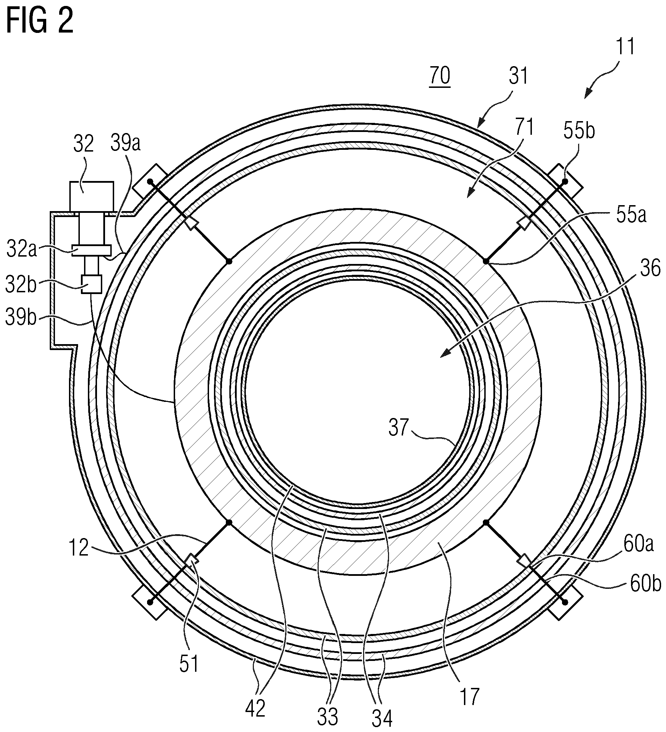

Fig. 2 shows a sectional view of the inventive magnetic resonance device 11 shown in Fig. 1. In the depicted example, the outer vacuum chamber 42 provides an outer enclosure for the components of the field generation unit 30, such as the shielding assembly 31 and the main magnet 17. Particularly, the outer vacuum chamber 42 separates a surrounding environment 70 from a vacuum region 71 encompassed by the outer vacuum chamber 42. The outer vacuum chamber 42 may represent a double-walled hollow cylinder comprising an outer shell and an inner shell connected via annular end walls (not shown). The inner shell of the outer vacuum chamber 42 may correspond to a patient bore 37 enclosing the imaging region 36 in a circumferential direction.

In the example shown in Fig. 2, the shielding assembly 31 comprises an inner thermal shield 33 and an outer thermal shield 34. Both the inner thermal shield 33 and the outer thermal shield 34 may be formed as double-walled hollow cylinders having annular end walls (not shown) according to an embodiment described above. The inner thermal shield 33 and the main magnet 17 may be enclosed between an outer wall and an inner wall of the outer thermal shield 34. The main magnet 17 may be enclosed between an outer wall and an inner wall of the inner thermal shield 33.

The shielding assembly 31 comprises one or more suspension rods 12 mechanically connected to the outer vacuum chamber 42 and the main magnet 17. The suspension rods 12 extend through passages 60a in the inner thermal shield 33 and passages 60b in the outer thermal shield 34 to provide a mechanical connection between the outer vacuum chamber 42 and the main magnet 17.

The magnetic resonance device 11 further comprises a cryocooler 32 mounted on the outer vacuum chamber 42. The cryocooler 32 may be configured to cool the main magnet 17, the inner thermal shield 33, the outer thermal shield 34, but also other components of the field generation unit 30, such as a cryogen vessel (not shown).

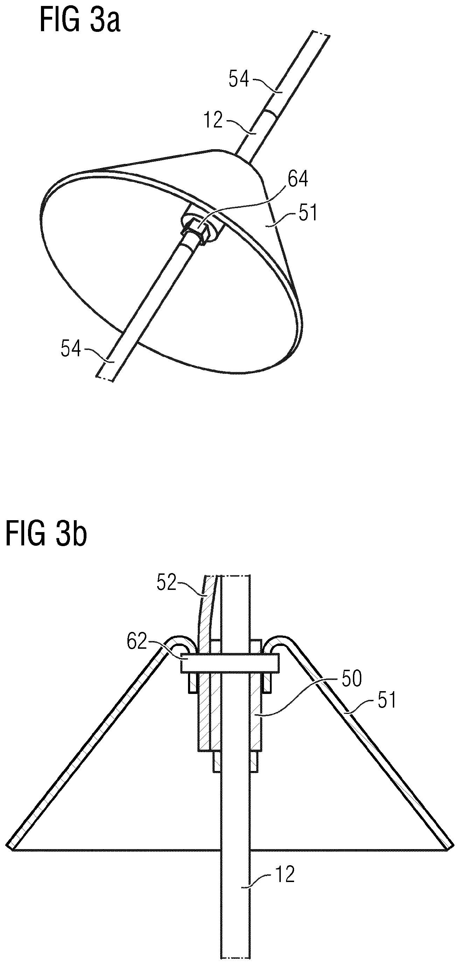

The cryocooler 32 typically comprises a compressor supplying pressurized gas to the cryocooler 32 (not shown). According to the embodiment shown in Fig. 3, the cryocooler 32 includes a cold head comprising one or more cooling stages 32a and 32b. Preferably, a first cooling stage 32a of the cold head is thermally connected to the outer thermal shield 34, whereas a second cooling stage 32b of the cold head is thermally connected to the main magnet 17. In a preferred embodiment, the first cooling stage 32a provides a temperature level of about 50 K, whereas the second cooling stage 32b provides a temperature level of about 4 K. In "dry" magnetic resonance devices, the cooling stages 32a and 32b of the cryocooler 32 may be mechanically connected to components of the field generation unit 30 via solid thermal conductors 39a and 39b. It is also conceivable that the magnetic resonance imaging device 11 comprises one or more small cryogen vessels (not shown) thermally connected to the cryocooler 32 via a solid thermal conductor, a heat pipe, and/or a convective loop. The one or more cryogen vessels may be thermally connected to the main magnet 17 via a heat exchanger and/or a solid thermal conductor 39.

During operation of the magnetic resonance device 11, the outer thermal shield 34 may be maintained at an intermediate temperature, e. g. between 40 K and 60 K, preferably about 50 K. The outer thermal shield 34 may comprise or consist of an electrically conductive material configured for shielding the main magnet 17 from blackbody radiation emitted in the region 72.

Figs. 3a and 3b show an embodiment of an inventive suspension rod 12. In the example depicted in Fig. 3a, the suspension rod 12 comprises a collar 51 having a shape of a cone. Sections of the shaft of the suspension rod 12 are wrapped in a low-emissivity, thermally insulating material 54, preferably one or more blankets of MLI. The suspension rod 12 comprises a threaded shaft and a nut 64, acting as an anchor element which prevents the collar 51 from sliding along the shaft of the suspension rod 12. Preferably, the collar 51 tapers towards a second end 55b (see Fig. 2) of the suspension rod 12, which is mechanically connected to the outer vacuum chamber 42. In other examples, the anchor element may be glued, clamped, crimped, swaged, and/or soldered to the suspension rod 12.

In the example depicted in Fig. 3b, the collar 51 is mechanically connected to a thermal intercept 50 via a fastener 62, such as a tie or a cable tie. Preferably, the thermal intercept 50 is clamped, swaged, glued, and/or soldered to the shaft of the suspension rod 12. The thermal intercept provides a thermal and mechanical connection between the shaft of the suspension rod 12 and the thermal link 52. In the depicted example, the thermal link 52 is arranged between the thermal intercept 50 and the collar 51. The cone of the collar 51 is inverted according to an embodiment described above to improve the stability of the collar 51.

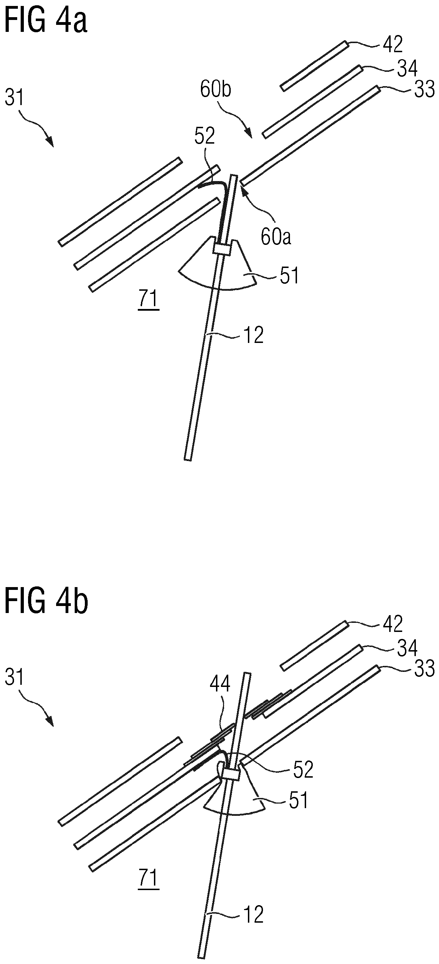

Figs. 4a and 4b show a schematic representation of an embodiment of an inventive shielding assembly 31. In the depicted examples, the suspension rod 12 comprises a collar 51 having the shape of a cone according to Fig. 3. Fig. 4a depicts an embodiment, wherein the suspension rod 12 is stowed within a region 71 encompassed by the inner thermal shield 34. The suspension rod 12 comprises a thermal link 52, which is routed through the passage 60a and thermally and mechanically connected to the outer thermal shield 34. Preferably, the thermal link 52 consists of a copper braid to allow for a relative movement between the suspension rod 12 and the outer thermal shield 34, for example when the suspension rod 12 is retracted from the region 71 (see Fig. 4b) and mechanically connected to the outer vacuum chamber 42 (see Fig. 2).

According to the embodiment depicted in Fig. 4a the suspension rod 12 is arranged far enough in region 71 that the outer thermal shield 34 and the outer vacuum chamber 42 can be slid or placed over the inner thermal shield 33. Once the inner thermal shields 33, the outer thermal shield 34 and the outer vacuum chamber 42 are arranged in their intended final positions, the suspension rod 12 can be pulled upwards, out of the region 71, and attached to the outer vacuum chamber 42.

The process of pulling the suspension rod 12 upwards moves the collar 51 into the passage 60a in the inner thermal shield 33 to block it (see Fig. 4b). The flexible material of the collar 51 compensates for any relative movement between the suspension rod 12 and the inner thermal shield 33, but also for build tolerances of the shielding assembly 31. If the inner thermal shield 33 is made of a flexible material, particularly a non-self-stabilizing material, the collar 51 and the suspension rod 12 may provide mechanical support to the inner thermal shield 33. Thus, a sagging of sections of the inner thermal shield 33 may favourably be reduced or avoided.

To seal the passage 60b, the outer thermal shield 34 may be wrapped in an assembly of MLI blankets 44. Preferably, at least one MLI patch of the assembly of MLI blankets 44 abuts against the thermally insulating material 54 wrapped around the suspension rod 12 (see Fig. 3). The at least one MLI patch may be taped to the assembly of MLI blankets 44.

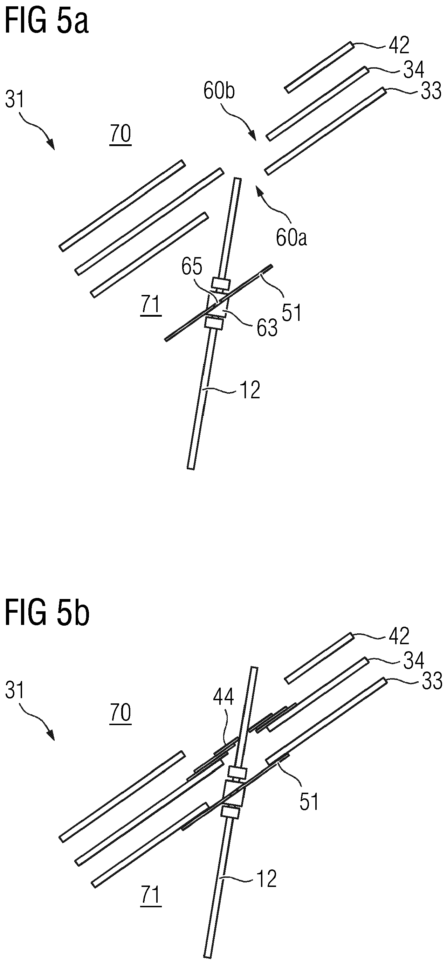

Figs. 5a and 5b show a representation of a further embodiment of an inventive shielding assembly 31. In the depicted embodiment, the collar 51 of the suspension rod 12 comprises the shape of a disk. The collar 51 is configured to abut against an inner surface of the inner thermal shield 33 and seal a gap between the inner thermal shield 33 and the suspension rod 12. Similar to the embodiment of the suspension rod 12 depicted in Figs. 4a and 4b, the suspension rod 12 shown in Figs. 5a and 5b is configured to be stowed in the region 71 to allow for the outer thermal shield 34 and the outer vacuum chamber 42 to be placed or slid over the inner thermal shield 33 (see Fig. 5a). When the suspension rod is pulled in the direction of the outer vacuum chamber 42 and mechanically connected to the outer vacuum chamber 42, the collar 51 abuts against the inner thermal shield 33 and seals the passage 60a (see Fig. 5b).

The collar 51 may be secured to the suspension rod 12 via any suitable mechanical connection, such as a nut (see Fig. 3a), a cable tie, or the like. Depending on an intended angle between the suspension rod 12 and the inner thermal shield 33, a base element 63 configured to hold the disk-shaped collar 51 in an orientation parallel to a surface of the inner thermal shield 33 may be provided. The base element 63 may hold the collar 51 in a fixed orientation with respect to the inner thermal shield 33. However, the base element 63 may also comprise a moveable joint 65 configured to variably adjust an orientation or angle of the collar 51 with respect to the surface of the inner thermal shield 33. According to an embodiment, the collar 51 is loosely mounted on the suspension rod 12, for example via a moveable joint 65. Thus, the collar 51 may orient itself correctly as it is pulled against the inner thermal shield 33.

A suspension rod 12 similar to the embodiments depicted in Figs. 5a and 5b may favourably be installed from the surrounding environment 70 after the thermal shields 33, 34 and the outer vacuum chamber 42 have been assembled. For example, the passage 60b may be larger than the passage 60a so that the collar 51 may pass through the passage 60b and rest on an outer surface of the inner thermal shield 33 (e. g. a surface of the inner thermal shield 33 facing towards the outer vacuum chamber 42), thus occluding the passage 60a. Furthermore, the suspension rod 12 may favourably compensate for build tolerances and relative movement between the suspension rod 12 and the inner thermal shield 33 in a local plane of the surface of the inner thermal shield 33 comprising the passage 60a.

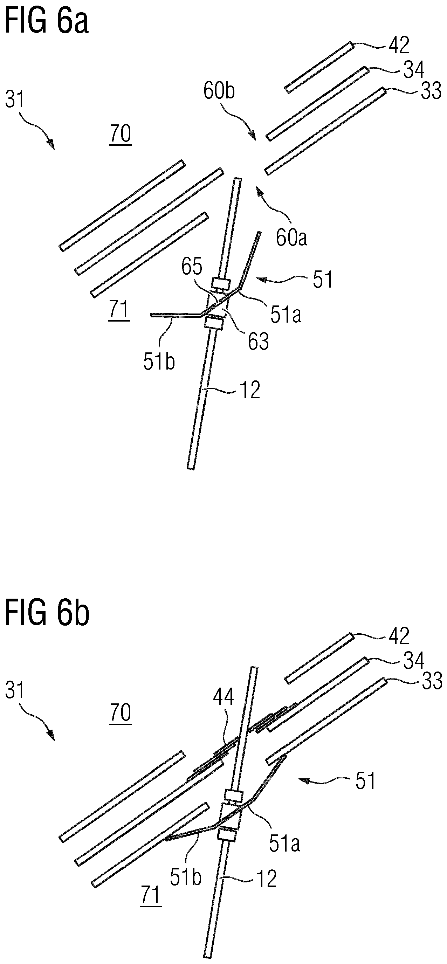

Figs. 6a and 6b show a representation of a further embodiment of an inventive shielding assembly 31. In the depicted embodiment, the collar 51 of the suspension rod 12 comprises a first section 51a and a second section 51b, wherein the first section 51a comprises the shape of a disk and wherein the second section 51b is angled with respect to the first section 51a.

The collar 51 can be made of a semi-rigid material according to an embodiment described above. Preferably, the collar 51 starts out as a flat disk, which is cut radially at multiple locations around a circumference of the disk. The resulting flaps can be folded to form a funnel or cone-like structure having a first section 51a and a second section 51b as depicted in Figs. 6a and 6b. The flaps of the second section 51b may be at least partially overlapping. Once formed into the cone-like section 51b, the flaps may compensate for movement along an axial direction of the suspension rod 12 as well as movement in a local plane of the surface of the inner thermal shield 33 comprising the passage 60a, whilst remaining relatively light tight. A process of installing the suspension rod 12 in the shielding assembly 31 may correspond to a process described with respect to the Figs. 4a, 4b, 5a, and 5b. In an embodiment, both sections 51a and 51b of the collar 51 depicted in Figs. 6a and 6b may comprise a cone shape.

In the example depicted in Fig. 6a, the collar 51 of the suspension rod 12 is attached to a moveable joint 65. However, the collar 51 may also be mounted onto the suspension rod 12 in a predefined position or orientation required for sealing the passage 60a in the inner thermal shield 33.

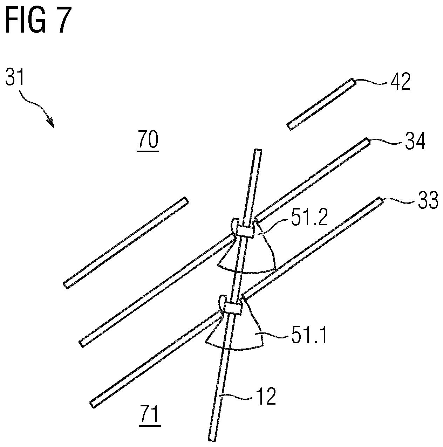

Fig. 7 shows a schematic representation of an embodiment of an inventive suspension rod 12 comprising a first collar 51.1 and a second collar 51.2. The collars 51.1 and 51.2 may be mechanically connected to the suspension rod 12 according to an embodiment described above. Preferably, the collars 51.1 and 51.2 are arranged in such a way, that the first collar 51.1 seals the passage 60a and the second collar seals the passage 60b, when the suspension rod is pulled towards the outer vacuum chamber 42 and/or mechanically connected to the outer vacuum chamber 42. A process of installing the suspension rod 12 in the shielding assembly 31 may correspond to a process described with respect to the Figs. 4a, 4b, 5a, and 5b.

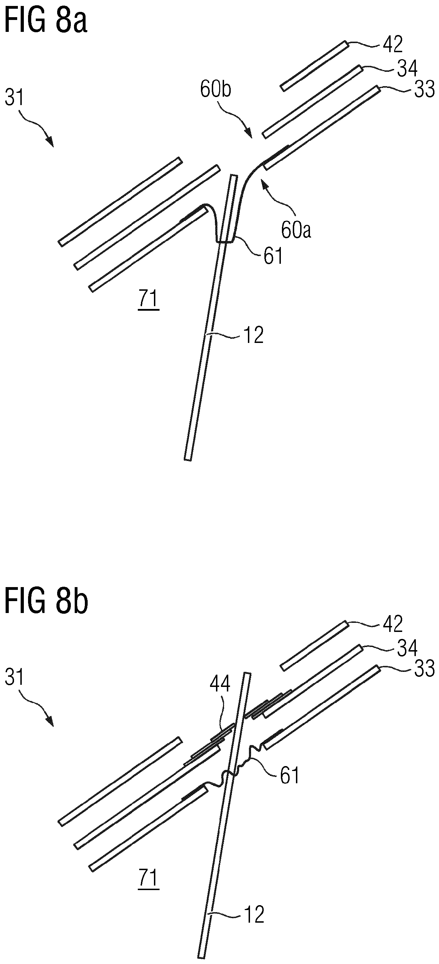

Figs. 8a and 8b show a representation of an alternative embodiment of an inventive shielding assembly 31, wherein the inner thermal shield 33 comprises a cover 61 comprising a thermally insulating material, wherein the cover 61 is mechanically attached to the inner thermal shield 33 in such a way to occlude the passage 60a in the inner thermal shield 33 and wherein the suspension rod 12 pierces the cover 61 to pass through the passage 60a in the inner thermal shield 33.

Preferably, the cover 61 forms a bag or sock at the passage 60a. In the depicted example, the cover 61 is attached to a surface of the inner thermal shield 33 facing towards the outer vacuum chamber 42. The cover 61 may be mechanically connected to the inner thermal shield 33 via a tape, an adhesive, rivets, staples, or the like. The bag or sock of the cover 61 may comprise a surplus of material to allow the bag or sock to extend through the passage 60a. The suspension rod 12 may slide through the sock. Preferably, the cover comprises or consists of a flexible, low-emissivity material according to an embodiment described above.

As depicted in Fig. 8a, the suspension rod 18 may be configured to be stowed in the region 71 in such a way that the outer shield 34 and the outer vacuum chamber 42 can be placed or slid over the inner thermal shield 33. Once the inner thermal shield 33, the outer thermal shield 34, and the outer vacuum chamber 42 are installed in an intended final position, the suspension rod 12 may be pulled out of the region 71 (see Fig. 8b) and attached to the outer vacuum chamber 42. The passage 60b in the outer thermal shield 34 may be sealed with an assembly of MLI blankets 44 as shown in Fig. 4a and 4b. In the embodiment depicted in Figs. 8a and 8b, the suspension rod 12 is preferably guided through the cover 61 before the outer thermal shield 34 and the outer vacuum chamber 42 are placed over the inner thermal shield 33.

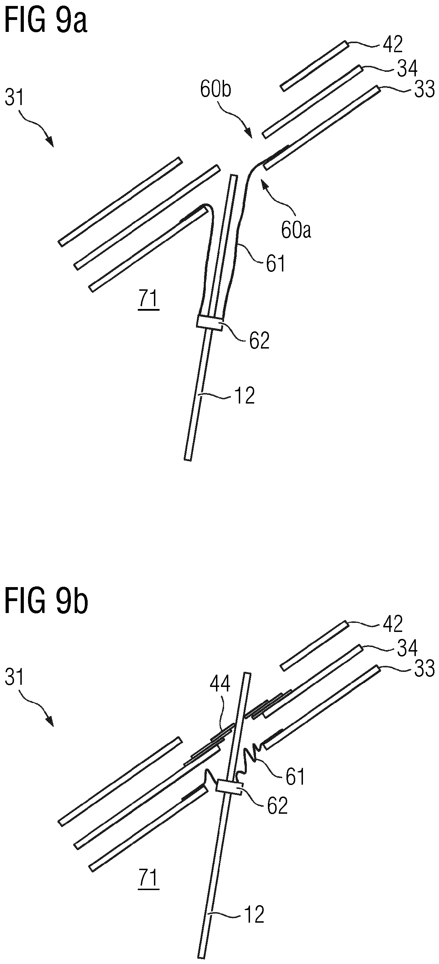

Figs. 9a and 9b show a representation of a further embodiment of an inventive shielding assembly 31. In the depicted embodiment, the shielding assembly 31 comprises a fastener 62 configured to attach a part of the cover 61 to the suspension rod 12.

According to the embodiment shown in Figs. 9a and 9b, the cover 61 forming the bag or sock comprises a significant surplus of material. The bag or sock is bonded to the suspension rod 12 via a suitable fastener 62, such as a tape, a cable tie, but also an adhesive bond, or any other suitable fastening mechanism. As a result, the suspension rod 12 is prevented from sliding through the cover 61.

Preferably, the suspension rod 12 is configured to be stowed in region 71 in such a way that the outer thermal shield 34 and the outer vacuum chamber 42 can be slid or placed over the inner thermal shield 33. In the stowed position illustrated in Fig. 9a, the part of the cover 61 forming the sock may be pulled out to a maximum length. Once the inner thermal shield 33, the outer thermal shield 34 and the outer vacuum chamber are mounted in the intended final position (i. e. to form the shielding assembly depicted in Fig. 9b) the suspension rod 12 can be pulled out of the region 71 and attached to the outer vacuum chamber 42. Thus, the sock of the cover 61 transitions to a slack, gathered-up state.

The passage 60b in the in outer thermal shield 34 can be sealed via an assembly of MLI blankets 44 as shown in Fig. 9b. In the embodiment depicted in Figs. 9a and 9b, the suspension rod 12 is preferably guided through and fastened to the cover 61 before the outer thermal shield 34 and the outer vacuum chamber 42 are placed over the inner thermal shield 33.

The embodiments described herein are to be recognized as examples. It is to be understood that individual embodiments may be extended by or combined with features of other embodiments if not stated otherwise. The embodiments depicted in the Figs. 1 to 9 are representations that do not necessarily have to be to scale.

## Claims

1. Suspension rod (12) for suspending a main magnet (17) of a magnetic resonance device (11), comprising a first end, a second end, and a collar (51) configured for deflecting thermal radiation, wherein the collar (51) is mechanically connected to the suspension rod (12) and wherein the collar (51) circumferentially encompasses the suspension rod (12) along a section of the suspension rod (12) located between the first end and the second end.

2. Suspension rod (12) according to claim 1, wherein the collar (51) consists of a flexible material and comprises the shape of a cone.

3. Suspension rod (12) according to claim 1, wherein the collar (51) comprises a rigid or semi-rigid material and comprises the shape of a disk.

4. Suspension rod (12) according to claim 1, wherein the collar comprises a semi-rigid material, wherein the collar comprises a first section (51a) and a second section (51b), wherein the first section (51a) comprises the shape of a disk or a cone and wherein a lateral surface of the second section (51b) is angled with respect to a lateral surface of the first section (51a).

5. Suspension rod (12) according to one of the preceding claims, wherein a longitudinal axis of the collar (51) is angled with respect to a longitudinal axis of a shaft of the suspension rod (12).

6. Suspension rod (12) according to one of the preceding claims, wherein the collar comprises a low-emissivity material.

7. Suspension rod (12) according to one of the preceding claims, comprising a thermal intercept (50) including a thermal link thermally and mechanically connected to the thermal intercept (50), wherein the thermal intercept (50) is configured for thermally connecting the suspension rod (12) to a cold source and wherein the thermal intercept (50) is thermally and mechanically connected to a section of the suspension rod located between the first end and the collar (51), wherein the thermal link is spaced from the suspension rod (12) along a section of the suspension rod (12) located between the thermal intercept (50) and the second end.

8. Shielding assembly (31), comprising a suspension rod (12) according to one of the preceding claims, a thermal shield (33), and an outer vacuum chamber (42), wherein the second end of the suspension rod (12) is mechanically connected to the outer vacuum chamber (42) and wherein the suspension rod (12) is routed through a passage (60a) in the thermal shield (33), wherein the collar (51) is configured to engage with the thermal shield (33) and cover a gap between the thermal shield (33) and the suspension rod (12).

9. Shielding assembly (31) according to claim 8, comprising a further thermal shield (34), wherein the suspension rod (12) is routed through a passage (60b) in the further thermal shield (33a) and wherein the further thermal shield (34) comprises a thermal insulation configured to cover a gap between the further thermal shield (34) and the suspension rod (12).

10. Shielding assembly (31) according to claim 8, comprising a further thermal shield (33a), wherein the suspension rod (12) is routed through a passage (60b) in the further thermal shield (34) and wherein the suspension rod (12) comprises a further collar (51) configured to engage with the further thermal shield (34) and cover a gap between the further thermal shield (34) and the suspension rod (12).

11. Shielding assembly (31) according to one of the claims 9 or 10, comprising a suspension rod (12) according to claim 7, wherein the thermal link is thermally and mechanically connected to the further thermal shield (34).

12. Shielding assembly (31), comprising a suspension rod (12), a thermal shield (33), and an outer vacuum chamber (42), wherein the second end of the suspension rod (12) is mechanically connected to the outer vacuum chamber (42) and wherein the suspension rod (12) is routed through a passage (60a) in the thermal shield (33), wherein the thermal shield (33) comprises a cover comprising a thermally insulating material, wherein the cover (61) is mechanically attached to the thermal shield (33) in such a way to occlude the passage (60a) in the thermal shield (33) and wherein the suspension rod (12) pierces the cover (61) to pass through the passage (60a) in the thermal shield (33).

13. Shielding assembly (31) according to claim 12, wherein the cover is mechanically connected to a surface of the thermal shield (33) comprising the passage (60a) and wherein the cover forms a protrusion arranged over the passage (60a) in the thermal shield (33).

14. Shielding assembly (31) according to claim 13, comprising a fastener configured to attach a part of the cover to the suspension rod (12).

15. Magnetic resonance device (11), configured to acquire magnetic resonance data from an object positioned within an imaging region of the magnetic resonance device and comprising a shielding assembly (31) according to one of the claims 8 to 14.
